(19) Europäisches Patentamt
European Patent Office
Office européen des brevets

(11) Veröffentlichungsnummer: **0 094 563**
**A2**

(12) # EUROPÄISCHE PATENTANMELDUNG

(21) Anmeldenummer: 83104411.0

(22) Anmeldetag: 05.05.83

(51) Int. Cl.³: C 25 B 3/00
C 25 B 3/02, H 01 M 4/60
H 01 B 1/12, C 08 G 61/00
C 07 C 15/56, C 07 C 113/04
B 01 J 31/02

(30) Priorität: 14.05.82 DE 3218229

(43) Veröffentlichungstag der Anmeldung:
23.11.83 Patentblatt 83/47

(84) Benannte Vertragsstaaten:
BE DE FR GB NL

(71) Anmelder: BASF Aktiengesellschaft
Carl-Bosch-Strasse 38
D-6700 Ludwigshafen(DE)

(72) Erfinder: Naarmann, Herbert, Dr.
Haardtblick 15
D-6719 Wattenheim(DE)

(72) Erfinder: Schlag, Johannes, Dr.
Leuschnerstrasse 36
D-6700 Ludwigshafen(DE)

(72) Erfinder: Koehler, Gernot, Dr.
Berner Weg 32
D-6700 Ludwigshafen(DE)

(54) **Verfahren zur Herstellung elektrisch leitfähiger kondensierter aromatischer Verbindungen, die nach dem Verfahren hergestellten Produkte und deren Verwendung.**

(57) Verfahren zur Herstellung von mehrkernigen, kondensierten aromatischen Verbindungen mit hohen elektrischen Leitfähigkeiten durch elektrochemische Umsetzung von Diazonium-Salzen der mehrkernigen, kondensierten aromatischen Verbindungen mit einer ionisierbaren Verbindung als Leitsalz, die in ionische Dotierungsmittel ionisierbar ist. Nach diesem Verfahren werden elektrisch leitfähige kondensierte aromatische Verbindungen definierter Zusammensetzung mit elektrischen Leitfähigkeiten über $10^{-4}\ \Omega^{-1}\ cm^{-1}$, insbesondere über $10^{-2}\ \Omega^{-1}\ cm^{-1}$ erhalten.

EP 0 094 563 A2

Croydon Printing Company Ltd

Verfahren zur Herstellung elektrisch leitfähiger kondensierter aromatischer Verbindungen, die nach dem Verfahren hergestellten Produkte und deren Verwendung

Die Erfindung betrifft ein Verfahren zur Herstellung von mehrkernigen, kondensierten aromatischen Verbindungen mit hoher elektrischer Leitfähigkeit durch Dotieren der kondensierten aromatischen Verbindungen mit ionischen Dotierungsmitteln. Die Erfindung betrifft ferner die so hergestellten elektrisch leitfähigen Verbindungen sowie deren Verwendung in der Elektroindustrie und zur antistatischen Ausrüstung von Kunststoffen.

Aus der EP-A2-36118 ist es bekannt, die elektrische Leitfähigkeit von konjugierten Polymeren durch elektrochemische Dotierung zu erhöhen. Hierzu werden die konjugierten Polymeren als Anode und/oder Kathode einer elektrolytischen Zelle eingesetzt, wobei der Elektrolyt eine ionisierbare Verbindung enthält, die in ein oder mehrere ionische Dotierungsmittel ionisiert werden kann. Als konjugierte Polymere sind beispielsweise auch Polyphenylene genannt. Die elektrochemische Dotierung von Oligo- und Polyphenylenen zur Herstellung elektrisch leitfähiger Substanzen ist auch in der EP-A1-16305 angesprochen.

Es ist weiterhin die elektrochemische Oxidation von kondensierten aromatischen Ringsystemen, wie Perylen, Fluoranthren, Pyren und Triphenylen, im Zusammenhang mit der Untersuchung der elektrischen Leitfähigkeit derartiger Systeme beschrieben worden (vgl. Angew. Chem. 93 (1981), 360 ff; Mod. Cryst. Liqu. Cryst. 62 (1980), 181 ff). Aus der EP-A1-47907 ist darüberhinaus bekannt, Heteropolyaromaten, die auch kondensierte aromatische Ringsysteme enthalten können, durch elektrochemische Oxidation in elektrisch leitfähige Verbindungen zu überführen.

Rss/Ws

Bei all diesen bekannten Verfahren der elektrochemischen Oxidation von polyaromatischen Verbindungen geht man von den polyaromatischen Verbindungen als solchen aus. Die erhaltenen elektrisch leitfähigen Produkte sind sehr empfindlich gegen Sauerstoff und Feuchtigkeit, als auch hängt die erzielbare elektrische Leitfähigkeit stark von der Reinheit der eingesetzten polyaromatischen Verbindungen ab. An das Verfahren werden daher sehr hohe Anforderungen bezüglich Reinheit der Ausgangsprodukte gestellt, und es muß stets unter Schutzgasatmosphäre gearbeitet werden. Es besteht somit ein Bedarf, diese bekannten Verfahren zur elektrochemischen Oxidation von polyaromatischen Verbindungen so zu vereinfachen und auszugestalten, daß mit möglichst geringem Verfahrensaufwand elektrisch leitfähige Verbindungen mit hohem Reinheitsgrad und hoher, verbesserter elektrischer Leitfähigkeit erhalten werden.

In der älteren deutschen Patentanmeldung DE-A-32 10 546 wird vorgeschlagen, zur Herstellung von elektrisch leitfähigen Oligophenylen niedermolekulare aromatische Diazonium-Salze von linearen, d.h. nicht-kondensierten Phenylen-Verbindungen in Gegenwart von als Dotierungsmittel wirkenden Leitsalzen elektrochemisch umzusetzen. Der bei der elektrochemischen Oxidation aus den Diazoniumsalzen freigesetzte Stickstoff wirkt als internes Schutzgas und erleichtert die Herstellung von sehr reinen Produkten.

Der vorliegenden Erfindung liegt die Aufgabe zugrunde, ein Verfahren zur Herstellung von mehrkernigen, kondensierten aromatischen Verbindungen mit hohen elektrischen Leitfähigkeiten aufzuzeigen, das in einfacher und reproduzierbarer Weise durchzuführen ist und zu sehr reinen Produkten definierter Zusammensetzung und gesteigerter elektrischer Leitfähigkeit führt.

Diese Aufgabe wird erfindungsgemäß dadurch gelöst, daß man Diazonium-Salze der mehrkernigen, kondensierten aromatischen Verbindungen elektrochemisch, vorzugsweise anodisch, in Gegenwart von als Dotierungsmittel wirkenden Leitsalzen umsetzt.

Gegenstand der Erfindung ist demzufolge ein Verfahren zur Herstellung von mehrkernigen, kondensierten aromatischen Verbindungen mit hohen elektrischen Leitfähigkeiten durch elektrochemisches Dotieren der mehrkernigen kondensierten aromatischen Verbindungen mit ionischen Dotierungsmitteln, welches dadurch gekennzeichnet ist, daß man Diazonium--Salze der mehrkernigen kondensierten aromatischen Verbindungen elektrochemisch, vorzugsweise anodisch, in einem organischen, polaren Lösungsmittel mit ionisierbaren Verbindungen als Leitsalz umsetzt, die in ionische Dotierungsmittel ionisierbar sind.

Nach dem erfindungsgemäßen Verfahren ist es nicht nur möglich, elektrisch leitfähige kondensierte aromatische Verbindungen herzustellen, deren elektrische Leitfähigkeitswerte im Vergleich zu den Ausgangsverbindungen um viele Größenordnungen gesteigert sind und in einem sehr großen Bereich variiert und bei guter Stromausbeute für das jeweils verwendete System in Abhängigkeit von Spannung und Dauer der Spannungseinwirkung gezielt und leicht reproduzierbar eingestellt werden können. Sondern es ist auf Grund dieses Verfahrens gleichzeitig möglich, elektrisch leitfähige kondensierte aromatische Verbindungen definierter Zusammensetzung und vergleichsweise hohen Reinheitsgrades zu erlangen. Es hat sich nämlich gezeigt, daß in dem erfindungsgemäßen Verfahren der bei der anodische Oxidation aus den Diazonium-Salzen freigesetzte Stickstoff nicht nur als internes Schutzgas wirkt, sondern daß gleichzeitig die so in situ hergestellten mehrkernigen, kondensierten aromatischen Verbindungen - wenn überhaupt - nur in untergeordnetem und geringem Ausmaß zur weiteren Kondensation und Polymerbildung neigen. Die erhaltenen elektrisch leitfähigen Produkte sind je nach Verfahrensführung im allgemeinen entweder pulverförmig und zumindest teilweise mikrokristallin oder fallen direkt in Form großer Kristalle an. Sie lassen sich in einfacher Weise verformen und verarbeiten, sind luft- und lagerstabil und eignen sich auf Grund ihrer allgemein guten Eigenschaften hervorragend zum Einsatz in Anwendungsgebieten der Elektrotechnik.

Als Diazonium-Salze, die als Einsatzstoffe für das erfindungsgemäße Verfahren dienen, kommen insbesondere Verbindungen der allgemeinen Formeln

$$\left[N{\equiv}N{-}\!\left(K\right)\!{-}N{\equiv}N\right]^{2+}\ 2X^{-}$$

oder

$$\left[N{\equiv}N{-}\!\left(K\right)\!{-}N{\equiv}N\right]^{2+}\ X^{2-}$$

in Betracht, worin K der Rest eines mehrkernigen, kondensierten aromatischen Ringsystems und X ein geeignetes Gegenion, insbesondere $HSO_3^-$, $SO_4^{2-}$, $BF_4^-$, $Cl^-$ oder $ClO_4^-$, ist. Die mehrkernigen, kondensierten aromatischen Ringsysteme, die den Rest K bilden können, haben im allgemeinen ein Molekulargewicht von 128 bis 1 000. Als Beispiele hierfür seien genannt das Naphthalin, Anthracen, Carbazol, Perylen, Phenanthren, Coronen, Chrysen und Triphenylen. Die beiden Diazonium-Gruppen können an demselben aromatischen Kern angeordnet sein; im allgemeinen sind sie jedoch an verschiedenen Kernen des kondensierten aromatischen Ringsystems gebunden. Es können in dem erfindungsgemäßen Verfahren auch Gemische von entsprechenden Diazonium-Salzen eingesetzt werden, oder auch Diazonium-Salze mit nur einer oder auch mehr als zwei Diazonium-Salz-Gruppen. Als Beispiele für die

erfindungsgemäß einzusetzenden Diazonium-Salze seien genannt Anthracen-bis-diazoniumperchlorat, Naphthalin-bis-diazoniumfluorborat, Carbazol-bis-diazoniumsulfat, Perylen-bis-diazoniumfluoroborat, Coronen-bis-diazoniumchlorid und Chrysen-bis-diazoniumsulfat. Die Diazonium-Salze können in bekannter Weise aus den entsprechenden Diamin-Verbindungen hergestellt werden.

Als Leitsalze, die gleichzeitig auch die Dotierungsmittel für die kondensierten aromatischen Verbindungen darstellen, werden insbesondere ionisierbare Verbindungen des Typs $A^+B^-$ eingesetzt, wobei es sich bei diesen ionisierbaren Verbindungen zweckmäßigerweise um einfache Salze aus einem Kation $A^+$ und Anion $B^-$ handelt.

Das Kation $A^+$ kann dabei $H^+$, ein Alkalimetall-Kation, insbesondere $Li^+$, $Na^+$ oder $K^+$, ein Erdalkalimetall-Kation, insbesondere $Mg^{2+}$, $Ca^{2+}$ und $Ba^{2+}$, $NO^+$, $NO_2^+$, $R_4N^+$ oder $R_4P^+$ sein, wobei die Reste R, unabhängig voneinander, ein Wasserstoffatom, einen aliphatischen Rest, vorzugsweise mit 1 bis 6 C-Atomen, einen cycloaliphatischen Rest, vorzugsweise mit 6 bis 14 C-Atomen, oder einen aromatischen Rest, vorzugsweise mit 6 bis 14 C-Atomen, darstellen. Unter den Ammonium- und Phosphonium-Kationen sind die tertiären und quaternären bevorzugt, insbesondere diejenigen, in denen R einen Alkylrest mit 1 bis 4 C-Atomen darstellt. Als Beispiele für Ammonium-Kationen seien neben dem $NH_4^+$-Ion insbesondere das Tetra-n-butyl-, das Tetra-isopropyl- sowie das Tetra-ethyl-ammonium-Kation genannt. Bei den Phosphonium-Kationen kommen den Triphenyl- und Tri-n-butyl-phosphonium-Kationen besondere Bedeutung zu. Besonders bevorzugte Kationen sind die Alkalimetall-Kationen sowie die Tetraalkylammonium-Kationen.

Das Anion $B^-$ kann $SbF_6^-$, $SbCl_6^-$, $AsF_4^-$, $AsF_6^-$, $PF_6^-$, $BF_4^-$, $SO_4^{2-}$, $ClO_4^-$, $SO_3CF_3^-$, $Acetat^-$, $Benzoat^-$ und $Tosylat^-$ sein. Bevorzugte Anionen sind $SbF_6^-$, $SbCl_6^-$, $AsF_6^-$, $PF_6^-$, $BF_4^-$, $SO_4^{2-}$ und $ClO_4^-$.

Je nach dem gewünschten Dotierungsgrad und den angestrebten elektrischen Leitfähigkeitswerten beträgt die Leitsalzkonzentration in dem Elektrolyt im allgemeinen 0,001 bis 10, vorzugsweise 0,01 bis 1, Mol pro Liter Lösungsmittel. Als Leitsalze geeignete ionisierbare Verbindungen sind z.B. Tetrabutylammonium-tetrafluoroborat, Tetrabutylammonium-perchlorat, $Bu_4N^+PF_6^-$, $Bu_4N^+AsF_6^-$, $Bu_4N^+SbF_6^-$, $NO^+SbF_6^-$, $NO_2^+SbF_6^-$, $NO^+AsF_6^-$, $NO_2^+AsF_6^-$, $NO^+PF_6^-$, $NO_2^+PF_6^-$, $NO^+BF_4^-$, $NO_2^+BF_4^-$, $NO^+ClO_4^-$, Tributylphosphonium-tetrafluoroborat, Tributylphosphonium-perchlorat, $Li^+BF_4^-$,$Li^+AsF_6^-$, $Li^+ClO_4^-$, $K^+BF_4^-$, $HClO_4$ und $H_2SO_4$.

Das erfindungsgemäße Verfahren wird in Gegenwart einer organischen polaren Verbindung als Elektrolyt-Lösungsmittel durchgeführt, in der das Leitsalz gelöst oder suspendiert ist. Wenn mit Wasser mischbare organische Lösungsmittel Einsatz finden, kann zur Erhöhung der elektrischen Leitfähigkeit eine geringe Menge an Wasser, im allgemeinen bis zu 3 Gew.%, bezogen auf das organische Lösungsmittel, zugesetzt werden, auch wenn in der Regel in einem wasserfreien System gearbeitet wird. Das Lösungsmittel selbst sollte aprotisch sein. Bevorzugte Elektrolyt-Lösungsmittel sind z.B. Ether, wie Ethylenglykoldimethylether, Diethylenglykoldimethylether, Tetrahydrofuran und Dioxan, Aceton, Dimethylformamid, N-Methylpyrrolidon, Dimethylsulfoxid, Acetonitril oder Methylenchlorid. Die Lösungsmittel sind selbstverständlich so auszuwählen, daß sie in dem angewendeten Spannungsbereich stabil sind.

Das erfindungsgemäße Verfahren kann in einer einfachen, üblichen elektrolytischen Zelle oder Elektrolyse-Apparatur durchgeführt werden, bestehend aus einer Zelle ohne Diaphragma, zwei Elektroden und einer externen Stromquelle. Die Elektroden können dabei beispielsweise aus Graphit sein. Im allgemeinen werden jedoch zur Durchführung des erfindungsgemäßen Verfahrens zwei Edelmetallelektroden, bevorzugt Platinelektroden, verwendet. Dabei ist es günstig, wenn zumindest die Anode, insbesondere aber beide Elektroden, flächig ausgebildet sind. Die erfindungsgemäß einzusetzenden Diazonium-Salze werden in dem Elektrolyt--Lösungsmittel gelöst oder dispergiert. Hierdurch wird sichergestellt, daß die erhaltenen elektrisch leitfähigen Verbindungen gleichmäßig und vollständig dotiert sind. Die Diazonium-Salze werden dabei im allgemeinen in Konzentrationen von 0,001 bis 5 Mol/l Lösungsmittel eingesetzt, vorzugsweise in gesättigter Lösung und/oder dispergierter Form. Die dotierten Produkte scheiden sich dabei im allgemeinen entweder in Form von gut ausgebildeten Kristallen an der Anode ab oder sind als pulverförmiges Festprodukt leicht aus dem Elektrolyt-Lösungsmittel zu isolieren.

Außer der erwähnten einfachen elektrolytischen Zelle ohne Diaphragma können auch andere Elektrolyseeinrichtungen für das erfindungsgemäße Verfahren Einsatz finden, beispielsweise Zellen mit Diaphragma oder solche mit Referenzelektroden zur exakten Potentialbestimmung. Auch kann die Messung der Strommenge (Asec) zweckmäßig sein.

Temperatur und Druck, unter denen die elektrochemische Dotierung durchgeführt wird, können in dem erfindungsgemäßen Verfahren in Abhängigkeit von dem jeweiligen System eingestellt und variiert werden. Normalerweise führt man die Reaktion bei Raumtemperatur durch. Es kann jedoch je nach System auch eine andere Temperatur gewählt

werden, solange die Erstarrungstemperatur bzw. Siedetemperatur des Elektrolyt-Lösungsmittels nicht unter- bzw. überschritten wird. Im allgemeinen hat sich eine Reaktionstemperatur im Bereich von -40 bis +40°C als sehr vorteilhaft erwiesen. Auch wenn bei geeigneten Vorkehrungen unter Unter- oder Überdruck gearbeitet werden kann, wird das erfindungsgemäße Verfahren üblicherweise unter Normaldruck durchgeführt. Es ist empfehlenswert, wenn auch nicht zwingend notwendig, das Verfahren unter einer äußeren Inertgas-Atmosphäre durchzuführen.

Als Stromquelle für den Betrieb der elektrolytischen Zelle, in der das erfindungsgemäße Verfahren durchgeführt wird, eignet sich jede Gleichstromquelle, wie z.B. eine Batterie, die eine hinreichend hohe elektrische Spannung liefert. Die Höhe der jeweils notwendigen Spannung hängt hauptsächlich von dem jeweiligen System (eingesetztes Diazonium-Salz, Leitsalz, Lösungsmittel) und dem gewünschten Dotierungsgrad ab. Sie soll nicht unnötig hoch gewählt werden; zweckmäßig benutzt man eine Spannung im Bereich von etwa 1 bis 25 Volt; als besonders vorteilhaft haben sich Spannungen im Bereich von etwa 2 bis 12 Volt erwiesen. Die Dauer der Spannungseinwirkung hängt von der Höhe der angelegten Spannung, der Stromdichte und dem gewünschten Dotierungsgrad ab. Im allgemeinen läßt sich der gewünschte Dotierungsgrad innerhalb von einigen Stunden erreichen. Die Stromdichte liegt üblicherweise im Bereich von 0,05 bis 100 $mA/cm^2$, vorzugsweise im Bereich von 0,1 bis 20 $mA/cm^2$.

Die dotierten kondensierten aromatischen Verbindungen können in einfacher Weise von der Anode, z.B. mechanisch oder durch Abspülen, abgetrennt oder aus der Elektrolyt-Lösung isoliert werden. Zur Entfernung von anhaftendem Leitsalz werden die erhaltenen Produkte mit einem geeigneten Lösungsmittel gewaschen und bei Temperaturen von 30 bis 150°C, vorzugsweise unter Vakuum getrocknet. Man erhält auf diese Weise im allgemeinen entweder Kristalle oder pulverförmige Substanzen, die zumindest teilweise eine mikrokristalline Struktur aufweisen. Die erhaltenen dotierten kondensierten aromatischen Verbindungen sind elektrisch leitfähig und besitzen eine definierte Struktur bei vergleichsweise hohem Reinheitsgrad.

Durch das erfindungsgemäße Verfahren werden Anstiege in der elektrischen Leitfähigkeit von einigen Größenordnungen erzielt. Die Ausgangsleitfähigkeiten von undotierten mehrkernigen kondensierten aromatischen Verbindungen liegen im allgemeinen unter $10^{-10}\Omega^{-1}cm^{-1}$. Die erfindungsgemäß hergestellten Produkte haben elektrische Leitfähigkeiten im allgemeinen größer als $10^{-4}\Omega^{-1}cm^{-1}$, wobei elektrische Leitfähigkeiten von $10^{-2}\Omega^{-1}cm^{-1}$ bis zu $10^{2}\Omega^{-1}cm^{-1}$ und mehr erzielt werden können. Die elektrische Leitfähigkeit wird durch Kontaktierung der Produkte mit Leitsilber und Messung nach der Zweipunkt-Methode bestimmt. Identische Ergebnisse erhält man durch Messung nach der Vierpunkt--Methode, wobei die Übergangswiderstände der Kontaktierung keine Rolle spielen können.

Die erfindungsgemäß hergestellten elektrisch leitfähigen, kondensierten aromatischen Verbindungen können zur Herstellung von Katalysatoren, Batterien, Schaltern, Halbleiter-Bauteilen und Solarzellen Einsatz finden. Die Produkte eignen sich auch beispielsweise zur antistatischen Ausrüstung von Kunststoffen.

Die nachfolgenden Beispiele erläutern die Erfindung. Die in den Beispielen genannten Prozente sind Mol.%.

Beispiele 1 bis 13

In einer Elektrolysezelle mit zwei Platinelektroden (3 cm x 3 cm Größe; Elektrodenabstand 2 cm) wurden die Elektrolytlösungen, die in dem in der nachfolgenden Tabelle angegebenen Lösungsmittel jeweils 0,01 % des jeweiligen Diazonium-Salzes und 0,02 % des jeweiligen Leitsalzes enthielten, 16 Stunden bei $-30^{o}C$ (Beispiele 1 bis 7) bzw. $+25^{o}C$ (Beispiele 8 bis 13) elektrolysiert (Spannung: 10 V, Stromstärke: 5 mA). Die erhaltenen Produkte hatten alle elektrische Leitfähigkeiten größer $10^{-1}$ $^{-1}$ $cm^{-1}$.

In der Tabelle bedeuten:

I $X^{\ominus}$ 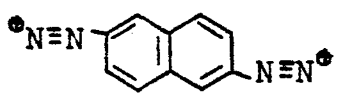 $X^{\ominus}$ mit $X = Cl^-$

| | | |
|---|---|---|
| II | wie I | mit $X = SO_3H^-$ |
| III | wie I | mit $X = ClO_4^-$ |
| IV | wie I | mit X = 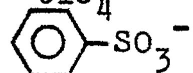 |
| V | wie I | mit $X = BF_4^-$ |
| VI | wie I | mit $X = AsF_6^-$ |

VII Perylen-bisdiazoniumfluorborat

VIII Chrysen-bisdiazoniumsulfat

IX Anthracen-bisdiazoniumperchlorat

X Coronen-bisdiazoniumchlorid

Tabelle

| Beispiel | Lösungsmittel | Diazonium-Salz | Leitsalz | Produkt |
|---|---|---|---|---|
| 1 | Methylenchlorid | I | $Et_4N^+ClO_4^-$ | 390 mg schwarz |
| 2 | Dimethylformamid | II | $Et_4N^+ClO_4^-$ | 410 mg schwarz |
| 3 | Dimethylformamid | III | $Et_4N^+AsF_6^-$ | 450 mg schwarz |
| 4 | Acetonitril | VII | $Bu_4N^+PF_6^-$ | 510 mg schwarz |
| 5 | Acetonitril | VIII | $Bu_4N^+PF_6^-$ | 470 mg violett |
| 6 | Acetonitril | IX | $Bu_4N^+PF_6^-$ | 530 mg schwarz |
| 7 | Acetonitril | X | $Bu_4N^+PF_6^-$ | 480 mg schwarzgrün |
| 8 | Acetonitril | I | $Bu_4N^+PF_6^-$ | 530 mg schwarz |
| 9 | Methylenchlorid | I | $Et_4N^+ClO_4^-$ | 450 mg schwarz |
| 10 | N-Methyl-pyrrolidon | IV | $Bu_4N^+ClO_4^-$ | 460 mg schwarz |
| 11 | N-Methyl-pyrrolidon | V | $Bu_4N^+ClO_4^-$ | 430 mg schwarz |
| 12 | Dimethylsulfoxid | VI | $Li^+ClO_4^-$ | 490 mg schwarz |
| 13 | Dimethylsulfoxid | IV | $K^+BF_4^-$ | 480 mg schwarz |

## Patentansprüche

1. Verfahren zur Herstellung von mehrkernigen, kondensierten aromatischen Verbindungen mit hohen elektrischen Leitfähigkeiten durch elektrochemisches Dotieren der kondensierten aromatischen Verbindungen mit ionischen Dotierungsmitteln, dadurch gekennzeichnet, daß man Diazonium-Salze der mehrkernigen, kondensierten aromatischen Verbindungen elektrochemisch, vorzugsweise anodisch, in einem organischen, polaren Lösungsmittel mit ionisierbaren Verbindungen als Leitsalz umsetzt, die in ionische Dotierungsmittel ionisierbar sind.

2. Verfahren nach Anspruch 1, dadurch gekennzeichnet, daß man als Leitsalz Verbindungen des Typs $A^+B^-$ einsetzt, worin $A^+$ ein Kation aus der Gruppe $H^+$, Alkalimetallion, Erdalkalimetallion, $R_4N^+$, $R_4P^+$, $NO^+$ und $NO_2^+$ sowie $B^-$ ein Anion aus der Gruppe $SbF_6^-$, $SbCl_6^-$, $AsF_4^-$, $AsF_6^-$, $PF_6^-$, $BF_4^-$, $SO_4^{2-}$, $ClO_4^-$, $SO_3CF_3^-$, $Acetat^-$, $Benzoat^-$ und $Tosylat^-$ bedeuten und die Reste R, unabhängig voneinander, ein Wasserstoffatom oder aliphatische, cycloaliphatische oder aromatische Reste sind.

3. Verfahren nach Anspruch 1, dadurch gekennzeichnet, daß man als Diazonium-Salz eine Verbindung der allgemeinen Formeln

$$\left[N{\equiv}N-\!\left(K\right)\!-N{\equiv}N\right]^{2+}\ 2X^-$$

oder

$$\left[N{\equiv}N-\!\left(K\right)\!-N{\equiv}N\right]^{2+}\ X^{2-}$$

einsetzt, wobei K ein mehrkerniges kondensiertes aromatisches Ringsystem und X ein geeignetes Gegenion ist.

4. Verfahren nach einem der Ansprüche 1 bis 3, dadurch gekennzeichnet, daß ein Diazoniumsalz des Naphthalins, Anthracens, Phenanthrens, Carbazols, Perylens, Chrysens, Coronens oder Triphenylens eingesetzt wird.

5. Verfahren nach Ansprüchen 1 bis 4, dadurch gekennzeichnet, daß das Leitsalz in einer Konzentration von 0,001 bis 10 Mol/l Lösungsmittel eingesetzt wird.

6. Verfahren nach Ansprüchen 1 bis 5, dadurch gekennzeichnet, daß die Diazonium-Salze der mehrkernigen kondensierten aromatischen Verbindungen in dem Elektrolyt-Lösungsmittel gelöst oder dispergiert in einer Konzentration von 0,001 bis 5 Mol/l Lösungsmittel eingesetzt werden.

7. Verfahren nach Ansprüchen 1 bis 6, dadurch gekennzeichnet, daß die elektrochemische Umsetzung mit einer Spannung im Bereich von 1 bis 25 Volt betrieben wird.

8. Elektrisch leitfähige, kondensierte aromatische Verbindungen, mit elektrischen Leitfähigkeitswerten größer als $10^{-4}\,\Omega^{-1}cm^{-1}$, hergestellt nach einem Verfahren gemäß Ansprüchen 1 bis 7.

9. Verwendung der elektrisch leitfähigen kondensierten aromatischen Verbindungen, hergestellt nach einem Verfahren gemäß Ansprüchen 1 bis 7, in der Elektrotechnik, insbesondere zur Herstellung von Katalysatoren, Batterien, Schaltern, Halbleiter-Bauteilen und Solarzellen.

10. Verwendung der elektrisch leitfähigen kondensierten aromatischen Verbindungen, hergestellt nach einem Verfahren gemäß Ansprüchen 1 bis 7, zur antistatischen Ausrüstung von Kunststoffen.